# EUROPEAN PATENT APPLICATION

(11) **EP 1 482 318 A2**
(43) Date of publication of application: **01.12.2004**
(21) Application number: 04253165.7
(22) Date of filing: 28.05.2004
(51) Int. Cl.: G01R 31/36

(54) **Battery life monitor and battery state of charge monitor**

(30) Priority: 29.05.2003 GB 0312303
(71) Applicant: YUASA BATTERY (UK) LIMITED, Ebbw Vale, Gwent NP3 5SD, Wales (GB)
(72) Inventor: Stevenson, Peter, Powys NP8 1NY (GB); Rees, Glynne, Salisbury, Wiltshire SP1 3FP (GB)
(74) Representative: Holt, Daniel Richard

(57) **Abstract**

The electrolyte inside a lead and acid battery is inaccessible and measurements of the voltage across a battery's terminals do not necessarily give a good indication of the future performance of a battery. Furthermore, although the state of charge of a battery can be determined from measurement of the voltage across its terminals, these measurements will be misleading unless they are taken when the battery is in equilibrium. Accordingly, the present invention proposes a battery monitor which takes measurements from a battery and is configured to detect one or more types of event affecting the battery life and to subtract a predetermined amount from a life counter representing the remaining available life of the battery, each time such an event is detected. The monitor is also configured to calculate the state of charge of the battery, but only when the battery is in equilibrium.

## Description

This invention relates to the monitoring and prediction of the remaining useful life of an electric storage battery, such as a Lead acid battery. It also relates to determination of the state of charge of the battery. It is thought that the present invention will assist current supply management for systems using batteries as alternative or primary sources of electric power.

The state of charge of a battery is a measure of the instantaneous energy level of the battery and is expressed as a percentage from 0%, when the battery is flat, to 100% for a fully charged battery, which has not yet been used. For a Lead acid battery the state of charge can be determined from the open circuit terminal voltage of the battery, as there is an approximately linear relationship between the two.

However the instantaneous state of charge of the battery does not give a good indication of the future life of the battery, or how many times it can be recharged before it will fail. Each time a Lead acid battery is discharged, and recharged, irreversible changes occur in the structure of the active components. These irreversible changes progressively degrade the ability of the battery usefully to store electrical energy. Eventually the ability of the battery to usefully store electrical energy is degraded to the point that the battery has to be replaced.

In this application the remaining "life" of the battery and similar terms refer to the remaining useful life (usually extending over many discharge/charging cycles) before this gradual degradation means that the battery can no longer function adequately and should be replaced. The point at which the battery should be replaced can be derived from the manufacturer's specification or criteria set by the battery's user. It may depend on the particular application and may be defined, for example, by the lowest acceptable battery capacity when the battery is fully charged. For example, the maximum acceptable degradation may be 60% of capacity; i.e. when due to degradation the battery, when fully charged, has a state of charge of only 60% (i.e. 60% of the maximum available capacity of the battery when it was new).

Previously the state of health of an electric storage battery has been monitored by measurements of the electrolyte specific gravity, internal resistance and battery voltage during a controlled discharge test. These methods require specialist test equipment, cannot be applied frequently and need detailed technical knowledge for the interpretation of the results.

Furthermore, it is intrinsic to sealed batteries that electrolyte is not accessible in the battery cells, and that the battery voltage is dependent on the conditions under which the battery is being used. These conditions include the ambient temperature and whether the battery is subject to a charge current or supplying a discharge current. Thus, when the state of charge is calculated from the terminal voltage, it is difficult to get a reliable reading of the terminal voltage from which to calculate the state of charge.

Another difficulty with the above approach is that the deliverable electrical capacity and the impedance of an electric storage battery do not change significantly during the majority of the life of the battery. Measurement of these characteristics as isolated events can only provide information about the current capability of the battery and does not allow predictive evaluation.

Towards the end of the battery's life, the capacity and impedance values of an electric storage battery change more rapidly and comparisons with earlier tests have been used to indicate that failure is imminent. When such measurements are made repeatedly, through the life of the battery, it is often difficult to assure that the tests are performed reproducibly and that records are maintained reliably enough for accurate technical evaluation to be performed.

GB2377833 discloses a battery monitor which indicates battery health by illuminating one of five LEDs on a display (each LED corresponding to a level of health from good to poor). The level of battery health is periodically estimated by determining the battery terminal voltage level as a percentage of the calibration voltage level measured when the battery was first used and adjusting this figure based on the change in battery internal resistance and voltage drop in service compared to that when the battery was first used. The resultant figure is used to decide which of the five LEDs to illuminate. However because the indicator is based on a comparison of instantaneous readings with the initial calibration, the battery's history is not properly taken into account. Therefore for some purposes the monitor may not give as accurate or timely prediction of the battery's future performance as desired. As noted above, in most cases the maximum state of charge and internal resistance of the battery only change significantly near the end of a battery's life, which limits the information given by this method.

US5895440 discloses a battery monitor which monitors the number of battery charging cycles, age of the battery and other parameters and displays them on an LCD display together with the measured state of charge of the battery. However, there is no analysis of these figures. Therefore the unskilled user is left essentially with no information on which to judge how much longer the battery will last and even the skilled user is in a similar position unless he has access to a calculating apparatus and/or battery tables.

The invention has been discussed above and will continue to be discussed below with reference to lead acid batteries and it is envisaged that the present invention will be particularly applicable to such batteries. However, the principles of the present invention can also be applied to other types of battery which have a measurable state of charge and which degrade over time with use.

The present invention aims to provide battery life monitor and/or a battery state of charge monitor that enables the above mentioned problems to be mitigated. In its various aspects the present invention may allow the battery user to:
- Plan preventative maintenance and battery replacement to avoid failure.
- Avoid modes of operation that may not be achievable towards the end of battery life.
- Provide information to make cost effective battery replacement strategies.

At its most general, one aspect of the present invention proposes a battery monitor that subtracts a predetermined amount from a battery life counter representing the remaining available life of the battery whenever an event is detected which affects the battery life. Usually the battery monitor will be able to respond to several types of event and each event type will have its own corresponding predetermined amount to be subtracted from the battery life counter. The events may comprise discharge/charge cycles, the age of the battery, and the amount of time the battery has spent in a charging state, idle state, discharging or in a state of over or undercharge. The predetermined amounts may be based on predetermined patterns of battery performance, e.g. empirical data or the battery manufacturer's specification. The predetermined amount may differ according to the parameters of a particular event, e.g. the depth of discharge of a detected discharge/charge cycle.

Accordingly a first aspect of the present invention may provide a battery monitor for use with a Lead acid battery comprising:
a monitor for taking measurements from the battery,
a memory for storing a life counter having a life counter value representing the remaining available life of the battery being monitored,
and a processor configured to detect one or more types of event based on measurements taken by the monitor and to debit the life counter when an event is detected by subtracting from the life counter value a predetermined amount corresponding to the detected event to give a new life counter value representing the remaining available battery life after the event has been detected.

In this way the battery's history is taken into account by subtracting a predetermined amount from the life counter each time an event is detected. Usually the life counter will be initialized with a predetermined initial value depending on the type of battery with which the monitor is to be used. The life counter value held by the life counter will then gradually decrease as the processor debits the life counter when events (such as charging and discharging) are detected.

Preferably the battery monitor is permanently connected to the terminals of the battery. This ensures that readings can be continuously taken and that the battery's entire history can be taken into account. Most preferably the battery monitor is connected to the terminals of the battery when the battery is new, this may be as part of the manufacturing process of the battery. The battery monitor is preferably mounted on the battery itself. It can conveniently be made integral with the battery or the battery casing. If the battery monitor is not integral with the battery then preferably it is mounted suitably close to the battery.

Preferably the battery monitor comprises a voltage sensor for measuring the voltage across the terminals of the battery. This information can be used by the processor to determine if the battery is charging, discharging or to gauge the open circuit terminal voltage of the battery. It can also be used to calculate the state of charge of the battery.

Preferably the processor is capable of measuring the rate of change of voltage sensed by the voltage sensor. This enables the processor to use only the voltage readings taken when there is not excessive fluctuation, i.e. when the rate of change is below a given threshold.

Preferably the events comprise a battery discharge/charge cycle. Each time the battery is discharged and then recharged its life is reduced, so the processor subtracts a corresponding predetermined amount from the life counter. The degradation of the battery from a discharge/charge cycle is related to the depth of discharge of the cycle. Therefore the predetermined amount is preferably based on the depth of discharge of the cycle, which may be assumed to be the depth of discharge before the processor detected the charging part of the cycle.

A discharge/charge cycle of the battery can be detected on the assumption that the battery is charged (by the user) after it has been discharged. Thus, the processor can be configured to debit the appropriate predetermined amount for a discharge/charge cycle when it detects that a new charging event has begun. The processor may be configured to detect that the battery is charging when the voltage across the battery terminals detected by the monitor exceeds a first predetermined threshold. This first predetermined threshold may be the maximum possible theoretical open voltage of the battery, on the assumption that if the battery terminal voltage exceeds this then it must be due to an external voltage being applied across the terminals of the battery. However, this can lead to erroneous detection of a charging event due to small, random fluctuations in the battery terminal voltage. Therefore, it is preferred that the first predetermined threshold is significantly greater than the maximum possible open circuit terminal voltage of the battery; preferably at least 1% greater, more preferably at least 2, 3 or 4% greater. It is possible that the voltage across the terminals of the battery will dip during charging. Therefore it is preferred that the end of a battery charging event (i.e. when the battery is no longer charging) is determined by a drop of the voltage across the battery terminals to below a second predetermined threshold, which second predetermined threshold is less than said first predetermined threshold. Said second predetermined threshold may be below the maximum possible open circuit terminal voltage of the battery, for example 1% or 2% less. In one embodiment, where the battery monitor is for use with a battery having cells with a maximum possible open circuit voltage of 2.23 V per cell, the first predetermined threshold is 2.3 V per cell and the second predetermined threshold is 2.2 V per cell.

Independent from the degradation associated with each discharge/charge cycle, simply continuously charging a battery over an extended period of time can in itself degrade the battery. Therefore, the processor may be configured to subtract a predetermined amount from the life counter for each unit time it detects that the battery is charging. This debit of the life counter being in addition to any debit per discharge/charge cycle.

Preferably the events which the processor is configured to detect comprise one or more of the battery being in a state of over discharge, the battery being in a state of equilibrium and the battery being charged. Each of these battery conditions results in the life of the battery being reduced. Therefore the processor is configured to subtract a corresponding predetermined amount from the life counter according to the amount of time (e.g. measured in hours) that the battery is detected to be in each condition.

The various predetermined thresholds and debit amounts may be determined on the basis of the battery manufacturer's performance tables or empirical data relating to the battery with which the monitor is to be used. In most cases this approach should lead to the life counter value, stored in the life counter, accurately reflecting the health and future performance of the battery. However, there may be some 'dud' batteries which are defective. Equally, if a battery is used to power faulty equipment, then it may fail to perform as expected due to excessive demands made by the faulty equipment. It would be desirable to provide the battery monitor with a way of detecting such batteries and alerting the user that the battery may not perform as expected even if the life counter indicates that it is healthy. Therefore the processor may be configured to send an alert signal when the instantaneous voltage, across the terminals of the battery, detected by the monitor, falls below a predetermined threshold for at least a predetermined period of time or at least a predetermined number of times. Said predetermined threshold should be a relatively low value, which the terminal voltage of a healthy battery would not normally fall below, for example 70% of the maximum possible open circuit terminal voltage of the battery. The alert signal may be sent to a display to give a visual indication, for example by lighting an appropriate LED. Alternatively, it may give an audible signal.

Although the battery state of charge can be calculated from the open circuit terminal voltage of the battery, this is only possible if the battery is at or near a state of equilibrium. Accordingly a second aspect of the present invention may provide a battery state of charge measuring apparatus for use with a Lead acid battery comprising:
a voltage sensor for measuring the voltage across the terminals of the battery,
a rate of change measurer for measuring the rate of change with respect to time of the voltage across the terminals of the battery,
a state of charge calculator for calculating the state of charge of the battery based on the voltage measured by the voltage sensing means,
an equilibrium determiner for determining that the battery is in equilibrium when the rate of change of the voltage measured by the rate of change measuring means is below a predetermined level; and
an output means for outputting the calculated state of charge when the equilibrium determining means determines that the battery is in equilibrium.

In this way a relatively accurate reading of the state of charge can be achieved. Preferably the predetermined level is a threshold level below which the battery can be considered to effectively be in equilibrium.

The output means will usually output the calculated state of charge to a display means or a memory. Alternatively, it may output a signal to an external device.

The second aspect of the invention may be combined with the first aspect of the invention.

A dual function display may be provided for displaying the state of charge and state of life (as indicated by the life counter) of the battery, either alternately or simultaneously.

The battery monitor of the first aspect of the present invention may communicate battery history information to an external management system. It may be provided with a communication device for doing this, e.g. a data sending device for a non contacting data link. Preferably the information it is configured to communicate comprises one or more of: the number of charge cycles the battery has experienced, total charging time, total rest time, total discharge time, over-discharge time, mean depth of discharge, total operating time, maximum charging temperature, mean charging temperature, minimum voltage experience and the value of the life counter (i.e. the predicted remaining life of the battery).

Further preferred features of the first and second aspects of the invention can be found in the claims.

An embodiment of the present invention will now be described with reference to Figures 1 to 5 in which:
Figure 1 is a schematic diagram of a battery and a battery monitor according to the present invention;
Figure 2 is a schematic diagram of a state of charge measuring apparatus according to the present invention;
Figure 3 is a graph showing the relationship between open circuit terminal voltage and state of charge for a Lead acid battery;
Figure 4 is a graph showing the effect which the depth of discharge of a discharge/charge cycle has on the effective life of the battery;
Figure 5 shows a display panel for displaying the state of charge or alternatively the remaining available life of a battery;
Figure 6 is a flow chart showing the operation of a processor for determining the state of charge and remaining available life of a battery; and
Figure 7 is a graph showing instantaneous battery terminal voltage against time for a defective battery.

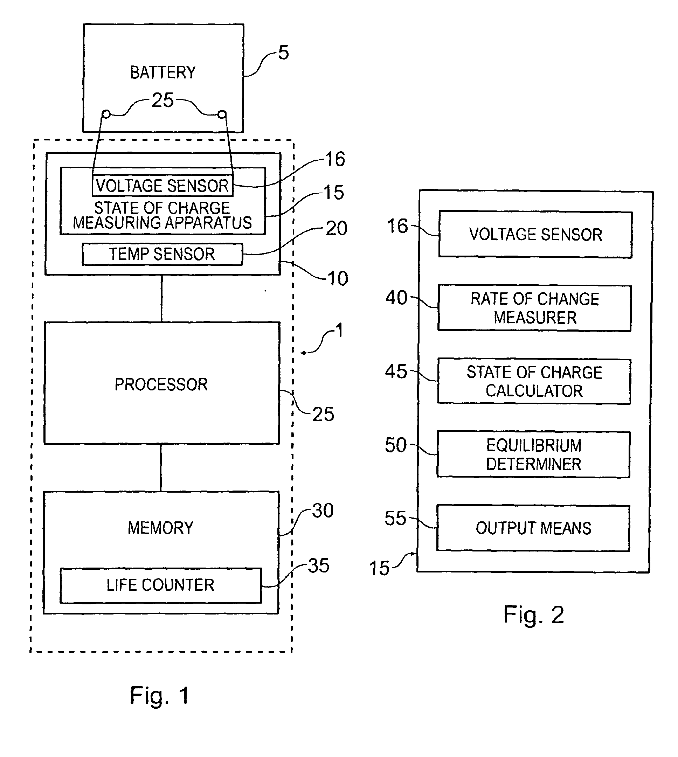

A battery monitor 1 shown schematically in Fig 1 is integrated into the casing of a Lead acid battery 5. The battery monitor 1 comprises a monitor 10 for taking measurements from the battery. The monitoring means comprises a state of charge measuring means 15 including a voltage sensor 16 which is permanently connected to the terminals 25 of the battery and configured to measure the voltage across the terminals 25. The monitor 10 also includes a temperature sensor 20 for measuring the temperature of the battery 5. Because the battery monitor 1 is integrated into the battery casing the temperature sensor 20 effectively reads the battery temperature. In alternative embodiments in which the battery monitor is not integral with the battery the temperature sensor may be mounted on the battery and transmit data to the monitor 10.

The battery monitor 1 also comprises a processor in the form of processor 25 and a memory 30 for storing a life counter 35 having a life counter value representing the remaining available life of the monitored battery 5. The processor 25 is configured to detect events occurring in the battery based on measurements taken by the monitor 10 and to debit the value held in the life counter 35 by a predetermined amount corresponding to the detected event. When the processor "debits" the life counter it subtracts the predetermined amount from the value stored in the counter to arrive at a new life counter value. The new life counter value which is then stored in the life counter represents the remaining available life of the battery after occurrence of the detected event.

The memory 30 may also contain data pertaining to the type of battery 5 which it is designed to monitor, for example the number of cells, maximum theoretical open circuit voltage per cell and data relating to predetermined patterns of expected battery performance taken from empirical data or the battery manufacturer's specification.

While the monitor 10, processor 25 and memory 30 have been shown separately in Fig 1 in practice they may be provided by a single integrated chip, although it may be convenient to have the voltage sensor, the temperature sensor and any other apparatus taking direct physical measurements as separate parts or devices.

As shown schematically in Fig 2, the state of charge measuring apparatus 15 comprises a voltage sensor 16, a rate of change measurer 40, a state of charge calculator 45, an equilibrium determiner 50 and an output means 55. While they are shown as separate parts in Fig 2, some or all of these parts may in fact be integrated together as a single chip or provided as a single dedicated processor or program running on a processor, as will be apparent to a person skilled in the art. The functions of the various parts will be described in more detail shortly, but first it is necessary to give some background.

The state of charge of the Lead acid battery 5 can only accurately determined from measurement of the open circuit terminal voltage (Voc) of the battery when there is a uniform acid concentration throughout the electrolyte volume of each cell of the battery. Typically this state of equilibrium can only be achieved after a stabilisation period, following either a charge or discharge event. The length of the stabilisation period will depend on the rate and duration of the previous charge or discharge event. In practice the battery never attains complete equilibrium even when there is no current flowing and conditions are stable. This is because a number of internal chemical reactions take place which result in loss of charge in the battery. So there will always be a continuous, but very slow background decay rate of the terminal voltage.

After a charge or discharge event, the rate of change decreases exponentially towards a stable voltage. This rate of change can be monitored, and once a sufficiently small value is reached it is indicative that an acceptably accurate state of charge value can be derived from the Voc measurement. For the purposes of this invention it is also acceptable to measure Voc when very small discharge currents continue to flow (e.g. due to background decay). Providing the voltage is stable, indicating that the difference from equilibrium conditions is negligible, the state of charge can be derived to within 5% of a true reading.

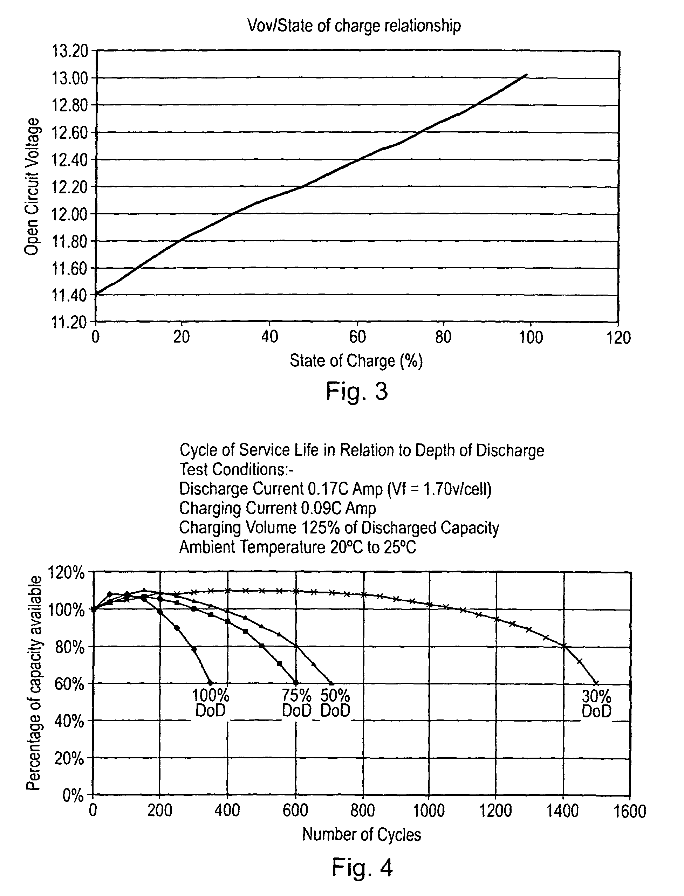

The relationship between the equilibrium Voc and state of charge for a particular model of valve regulated Lead acid battery is shown in the graph of Figure 3; the x-axis represents state of charge and the y-axis the open circuit terminal voltage when the battery is in equilibrium. The relationship is temperature dependent. The values shown in Fig 3 were recorded at 20°C. Therefore to calculate the state of charge accurately across the normal operating temperature range of the battery it is necessary to take account of the readings of the temperature measuring device 20 which is in intimate contact with the battery 5 that is being monitored.

The functions of the various notional components of the state of charge measuring means will now be described. There is a voltage sensor 16 which has already been described above, a rate of change measurer 40 for measuring the rate of change with respect to time of the voltage measured by the voltage sensor 16 and an equilibrium determiner 50 which determines whether or not the monitored battery 5 is in equilibrium on the basis of the rate of change of voltage measured by the rate of change measuring means 40. When the rate of change is below a predetermined threshold, it is determined that the battery 5 is in equilibrium. The threshold is chosen to be above the background decay level mentioned above.
In the present embodiment a threshold of 1.5mV per minute per battery cell (e.g. 9mV per minute if there are six cells) is used and the battery is deemed be in equilibrium if the rate of change is less than that. While it would in principle be possible to choose a lower threshold level down to the background decay rate, the resolution of the voltage sensing means and the expected time period between periods of charge and discharge need to be taken into account as these affect the minimum accurately measurable rate of change of the terminal voltage.

When the equilibrium determiner means 50 determines that the battery is in equilibrium, the state of charge calculator 45 calculates the state of charge of the battery 5. The state of charge is calculated based on the voltage measured by the voltage sensing means and taking account of the relationship between open circuit terminal voltage and state of charge for the battery in question (e.g. as shown in Fig 3) and the temperature measured by the temperature measuring device 20. The state of charge is then output to processing means 25 from where it may be output to a display of the battery monitor 1 as described later or to memory 30.

As the state of charge is only calculated when the battery is in equilibrium, a better accuracy is obtained than with prior art methods. Alternatively the state of charge may be calculated continuously, but only output when the battery is in equilibrium.

Optionally the equilibrium determiner 50 may also check that the battery is not being charged and only determine that the battery is in equilibrium if it is not being charged. The equilibrium determiner may be configured to determine that the battery is being charged when the voltage sensed by the voltage sensor is greater than the maximum possible open circuit voltage of the battery.

Operation of the processor 25 with regard to the memory 30 and the life counter 35 will now be described in more detail.

The life counter 35 in the memory 30 is initialized with an initial value when the battery monitor is first set up. The initial value is determined according to the characteristics of the battery type with which the battery monitor is to be used. The memory 30 may also contain instructions to be read by the processor and data relating to the predetermined amounts to be debited when events are detected.

The battery monitor 1 continually monitors the voltage at the battery terminals and the temperature of the battery as described above and also the elapsed time (by use of a timer in the processing means 25). This information is processed continually by the processor 25 to determine the mode of operation of the monitored battery 5 either as charging, discharging or open circuit state. Each of these modes has a different effect on the aging rate of the battery. The processor calculates the effects of each mode, based on data provided by the battery manufacturer, on the life of the product. The aging caused by each mode event is debited from a life counter that is initialised at the time of activation of the battery and battery monitor as explained above.

Each time that a Lead acid battery is discharged, and recharged, irreversible changes occur in the structure of the active components that progressively degrade the ability of the battery usefully to store electrical energy. Therefore one event which the processor 25 is configured to detect is a discharge/charge cycle of the battery.

The battery will be charged by the user after it has been discharged. Therefore, the processor is configured to detect a discharge/charge cycle of the battery when it detects that the battery 5 is being charged again after a period of non-charging. The processing means 25 determines that battery 5 is being charged when the voltage sensed by the voltage sensing means 16 is greater than a first predetermined threshold which is appreciably higher than the maximum possible open circuit voltage of the battery 5. In this embodiment the maximum possible open circuit terminal voltage is 2.23 V per cell of the battery, making a total of 13.38 V as the battery 5 has six cells.

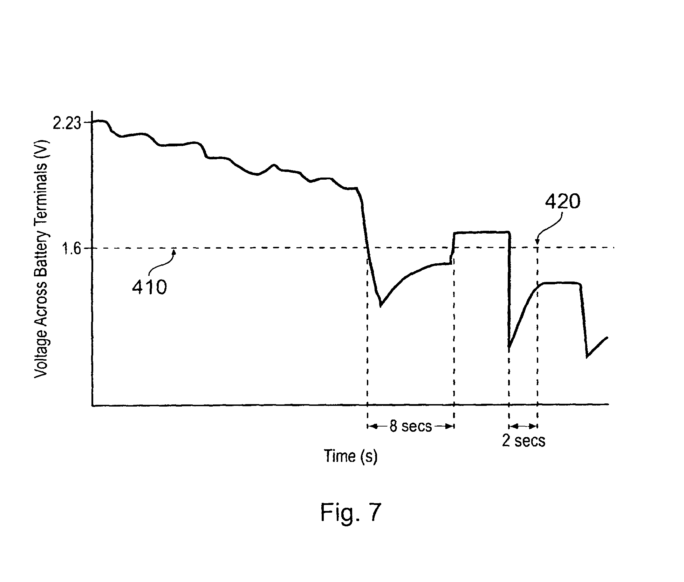

The first predetermined threshold is 2.3V per cell or 11.5V for a six cell battery. In general the thresholds and predetermined debit amounts discussed above may be set by reference to the battery manufacturer's reference tables or empirical data relating to the battery type with which the battery monitor is to be used. However, if the battery is defective or if it is used with fault equipment, then its performance may not reflect the expected standard given by this data. Therefore the processor 25 is configured to send an alert signal when the instantaneous voltage, detected by the monitor 10 across the terminals of the battery 5, falls below a predetermined threshold for at least a predetermined period of time. This threshold is a low voltage, which a healthy battery would not normally fall below. For example, 70% of the maximum possible open circuit terminal voltage of the battery. In the present embodiment, which is designed for a battery having a maximum possible open terminal voltage of 2.23 V per cell, this threshold is set at 1.6 V per cell. The alert signal is generated by the processor 25 when the total amount of time which the battery has spent with a terminal voltage below this threshold is equal to or greater than 10 seconds. Other embodiments will have a different threshold or a different predetermined period of time which must be exceeded in order to generate the alert signal. The appropriate values will be determined by the battery with which the battery monitor is to be used. Fig. 7 is a graph showing terminal voltage against time for a defective battery. The alert signal is generated at point 420 when the instantaneous terminal voltage (as detected by the voltage sensor 16) has dropped below the threshold 410 for a total of 10 seconds. This 10 seconds is made up from 2 successive drops below the threshold 410, the first lasting 8 seconds and the second lasting more than 2 seconds. The alert signal is then sent to a display to light an LED indicating that the battery is defective and/or liable to fail. This LED is not shown in the accompanying drawings illustrating the battery monitor display, but it can easily be added as will be appreciated by a person skilled in the art. In alternative embodiments the alert signal could be used to generate a different visual indication or even an audible alarm, so as to alert the user to the battery's status. The processor detects that the battery is no longer being charged (the end of a charge event) when the terminal voltage drops below a second predetermined threshold which is appreciably (e.g. 1%) below the maximum possible open circuit voltage of the battery. In this embodiment the second predetermined threshold is 2.2 V per cell. The first and second predetermined thresholds are set depending on the maximum possible open circuit voltage and the number of cells. They are entered into the memory 30 of the battery monitor when it is first set up. As will be clear to a person skilled in the art, the maximum possible open circuit voltage (both per cell and total) will depend on the type of battery being monitored.

When the processor detects a discharge/charge cycle event as described above it debits the life counter 35 by subtracting a predetermined amount from the value held in the life counter 35 to arrive at a new life counter value 35 reflecting the remaining life after the detected event has occurred. The predetermined amount that is subtracted is based on predetermined patterns of battery performance taken from the manufacturer's specification for the battery 5. However, not all discharge/charge cycles result in equal degradation of the battery, therefore the debited amount depends upon the characteristics of the detected discharge/charge cycle.

The main factor that determines the amount of degradation of each cycle is the depth of discharge. The depth of discharge of the battery is a measure of how much the battery was discharged during the discharge part of the discharge/charge cycle. It can be expressed as 100% - the state of charge of the battery at the end of the discharge part of the cycle. For example if the state of charge at the end of the discharge part of the cycle is 80% then the depth of discharge is 20%.
The relationship between the depth of discharge and cycle life (i.e. number of cycles in the useful life of the battery) for a particular type of Lead acid battery is illustrated in Figure 4. Figure 4 is a graph in which the x-axis represents the number of cycles and the y-axis represents the percentage of capacity available (measured from the battery state of charge after recharging) compared to the capacity of the battery when it was new. The line with crosses is where all the discharge cycles are to 30% depth of discharge, the line with triangles 50% depth of discharge, the line with squares 75% depth of discharge and the line with diamonds 100% depth of discharge. It can be seen that greater depths of discharge yield fewer cycles before the battery capacity is significantly reduced. Thus, if the available battery life is deemed to be up when the percentage of capacity is reduced to 60% then there is a cycle life of less than 400 cycles if the depth of discharge of the cycles is 100%, but around 1500 cycles if the depth of discharge of each cycle is only 30%.

Therefore the processor is configured to debit a predetermined amount from the life counter based on the measured depth of discharge of the detected discharge/charge cycle and predetermined patterns of battery performance such as those shown in Figure 4. The depth of discharge of the discharge/charge cycle is deemed to be the depth of discharge measured just before the processing means 25 detected that the battery 5 was being charged.

When a Lead acid battery is allowed to remain in a very low state of charge the degradation of the electrode plates is accelerated significantly, reducing life to a period of weeks rather than years. Therefore another event, which the processor 25 is configured to detect, is when the battery 5 is in a state of very low charge such that the battery performance will be permanently degraded (e.g. due to irreversible deterioration of active materials in the battery). The voltage level at which this occurs may depend on the particular type of battery being monitored. In the present embodiment the processor is configured to detect that the battery is in a state of 'over discharge' which will damage the battery when the voltage sensor measures a terminal voltage of less than 1.5V per cell of the battery (e.g. 9V if the battery has six cells, the overall voltage or number of cells of the battery being input into the memory 30 when the battery monitor is first set up). The processor monitors the amount of time which the battery 5 spends in this state of over discharge and debits (subtracts) a predetermined amount from the battery life counter 35 for each unit time (e.g. each hour) that it detects that the battery 5 is in a state of over discharge.

A common means of operating Lead Acid batteries is to attach them to a continuous DC electrical supply at a fixed voltage that will just allow sufficient current to flow into the fully charged battery to replace energy lost by spontaneous self discharge reactions. This is known as float charging. In this condition several corrosive side reactions also occur that degrade the life of the battery. Therefore, another event which the processor 25 is configured to debit from the life counter for, is when it detects that the battery is being charged.

The processor 25 is configured to detect that the monitored battery 5 is being charged as discussed above (with reference to the discharge/charge cycle). However, the debiting of life counter for charging of the battery is in addition to and independent of the debiting of the life counter each time a discharge/charge cycle is detected. The debit for charging is per unit time spent charging. The debit for a discharge/charge event is per discharge/charge event, as detected by the start of a new charging event.

The rate of degradation caused by charging is dependent both on battery temperature and charging voltage. By monitoring both these factors the device is able to derive life degradation for the specific conditions. The processor 25 records the time elapsed in the charging mode and debits the life counter by a suitable predetermined amount according to the specific conditions for each unit time elapsed in this mode.

Because the combination of components within a Lead acid battery are inherently thermodynamically unstable all Lead acid batteries have a finite life even if they are not subjected to periods of discharge and float charge. The rate of degradation is temperature dependent and by monitoring the amount of time elapsed during which the battery 5 is neither in charge, nor discharge, nor over-discharge mode the processor is able to debit the life counter 35 at a suitable rate (i.e. by a suitable predetermined amount per unit time the battery is idle and in none of the above modes). The processor detects that the battery 5 is idle when it detects that is in equilibrium (it does this by monitoring the rate of change of the voltage measured by the voltage sensor as discussed above) and that it is not charging.

The state of charge measured by the state of charge measuring apparatus 15 and the remaining available life of the battery as indicated by the life counter 35 may be stored in memory 30, they are displayed on a display of the battery monitor or state of charge measuring apparatus. The state of charge and available remaining life may be displayed on separate displays or both on the same display (either simultaneously or alternately by way of a toggle switch or dependent on the detected mode of operation of the battery). For example the battery monitor can display the remaining available life when it detects that the battery is charging and the state of charge of the battery when the battery is not in a charging mode.

The display may have simple coloured indicators (e.g. green, amber, red lights or LEDs) to indicate the state of charge or available life. Alternatively it may use traditional analogue gauge representation, digitally displayed values, or could communicate electronically via a communication port and suitable protocol with an external device.

In general the thresholds and predetermined debit amounts discussed above may be set by reference to the battery manufacturer's reference tables or empirical data relating to the battery type with which the battery monitor is to be used. However, if the battery is defective or if it is used with fault equipment, then its performance may not reflect the expected standard given by this data. Therefore the processor 25 is configured to send an alert signal when the instantaneous voltage, detected by the monitor 10 across the terminals of the battery 5, falls below a predetermined threshold for at least a predetermined period of time. This threshold is a low voltage, which a healthy battery would not normally fall below. For example, 70% of the maximum possible open circuit terminal voltage of the battery. In the present embodiment, which is designed for a battery having a maximum possible open terminal voltage of 2.23 V per cell, this threshold is set at 1.6 V per cell. The alert signal is generated by the processor 25 when the total amount of time which the battery has spent with a terminal voltage below this threshold is equal to or greater than 10 seconds. Other embodiments will have a different threshold or a different predetermined period of time which must be exceeded in order to generate the alert signal. The appropriate values will be determined by the battery with which the battery monitor is to be used. Fig. 7 is a graph showing terminal voltage against time for a defective battery. The alert signal is generated at point 420 when the instantaneous terminal voltage (as detected by the voltage sensor 16) has dropped below the threshold 410 for a total of 10 seconds. This 10 seconds is made up from 2 successive drops below the threshold 410, the first lasting 8 seconds and the second lasting more than 2 seconds. The alert signal is then sent to a display to light an LED indicating that the battery is defective and/or liable to fail. This LED is not shown in the accompanying drawings illustrating the battery monitor display, but it can easily be added as will be appreciated by a person skilled in the art. In alternative embodiments the alert signal could be used to generate a different visual indication or even an audible alarm, so as to alert the user to the battery's status.

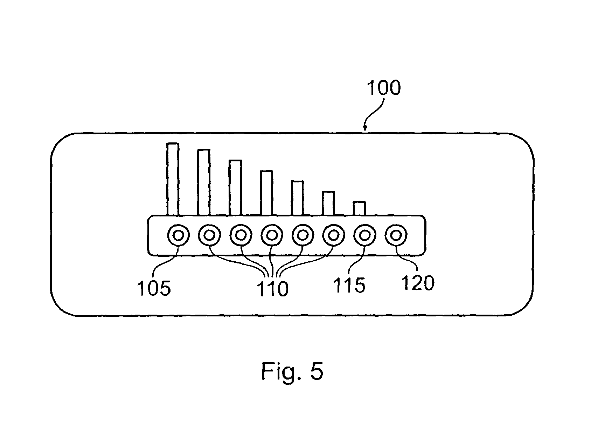

One suitable display will now be described and is shown in Figure 5. The display comprises a dual function display based on an array of light emitting diodes (LEDs). The display comprises 8 LEDs (although another number may be used; for reasons of resolution the number of LEDs will in most cases be a minimum of three and maximum of eight). The LEDs are arranged in a row. The first LED 105 is a green LED for showing full state of charge or full battery life available, the next five LEDs 110 are also green and are used to indicate progressively lower state of charge or lower amounts of remaining life. The seventh LED 115 is amber and is used to indicate very low state of charge or that the battery is close to the end of its life. The final, eighth, LED 120 in the array is red and is used to indicate a fully discharged battery (i.e. close to or at 0% state of charge) or that the end of the battery's useful life has been reached.

During discharge and open circuit periods (i.e. when the battery is not charging) the flashing of a relevant LED of the array indicates the state of charge. The duration, frequency and intensity the LED flashes may be chosen to limit discharge of the monitored battery to an acceptable level above the normal self discharge of the open circuit battery. During charging, when electrical supply is effectively unlimited, the LED array can be used to illuminate a relevant LED to indicate the state of life of the battery.
One or more of the LED units can also be used to transmit data concerning the battery 5 collected by the battery monitor 1 to a decoder and/or storage device where detailed information collated during the life of the battery can be analyzed further.

The dual information display for State of Life and State of Charge can be used to estimate the capability to perform particular discharge duties as the battery deteriorates towards the end of life. For example the State of Charge display may indicate that a particular duty cycle results in 90-100% depth of discharge of the battery. In this case it will not be possible perform this duty cycle for the full life duration indicated by the LED array. This is because the performance of the battery will fall below the initial level as indicated in Figure 4. In contrast a duty cycle resulting in only 50-60% depth of discharge will be supportable throughout the life indicated by the LED array.

This type of interaction between State of Charge and State of life (as represented by the life counter 35) is particularly useful where variable duty cycles are experienced in the battery application. For example where a battery is used to supply an electrically powered wheel chair, the available driving range will start to decrease before the battery becomes completely unserviceable. If the user only travels short distances a decision can be made delay replacement, but if a change to longer ranges is anticipated a decision can be made to purchase a new battery.

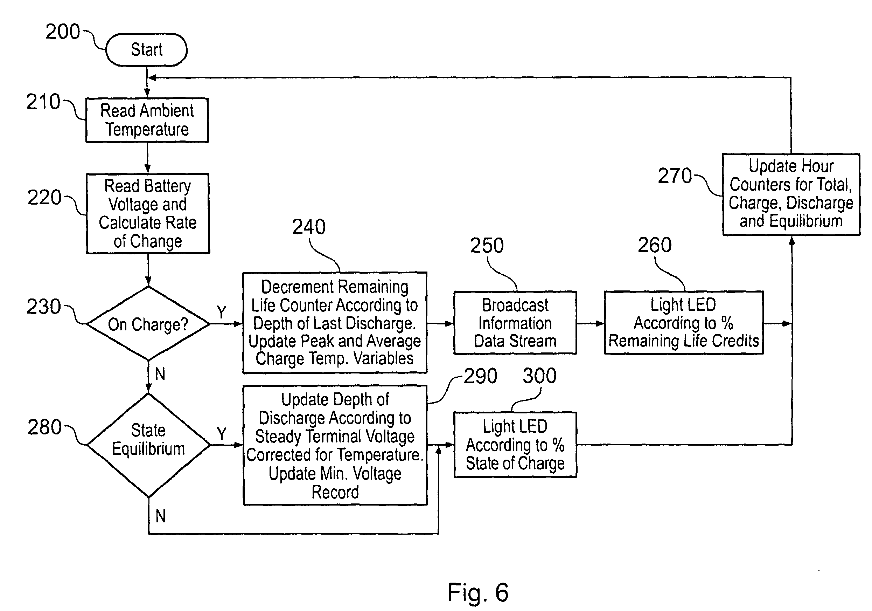

The functions of measurement, data processing and display may be carried out by way of a continuously recurring software routine embedded in the processing means 25. Figure 6 shows the operation of one suitable software routine. As will be apparent to a person skilled in the art, other routines would be possible. It would also be possible to have the software routine embedded on a custom made chip.

The routine starts in step 200 and progresses to step 210 where the processor 25 reads the ambient temperature detected by the temperature sensor 20 of the monitor 10. The processor 25 then reads the voltage across the battery's terminals as measured by the voltage sensor 16 and the rate of change of the voltage as measured by the rate of change measurer 40 of the state of charge measuring apparatus 15 in step 220. The processor than proceeds to step 230 in which it determines whether or not the battery 5 is being charged.
It determines that the battery 5 is being charged when the rate of change of the sensed terminal voltage is below a predetermined level and the measured terminal voltage is above a predetermined level corresponding to the maximum possible open circuit terminal voltage for the battery 5. These predetermined levels are set when the battery monitor is initialised and depend on the characteristics of the battery with which it is to be used. For the battery in the present embodiment, 1.5 mV volts per minute per battery cell is a suitable predetermined threshold level for the voltage rate of change and the maximum possible open circuit voltage of the battery 5 is 2.23 V per cell of the battery.

If at step 230 the processor 25 determines that the battery 5 is being charged (on charge) then it progresses to step 240 where the life counter is debited (decremented) according to the depth of the last discharge (as described above) which is stored in memory 30 and according to the average values of the detected temperature. In other words a predetermined amount corresponding to the detected discharge/charge cycle is subtracted from the value of the life counter 35. The new life counter value is broadcast in an information data stream to the display 200 in step 250 so that the appropriate LED is lit according to the remaining percentage of the battery's useful life as indicated by the life counter value, in step 260.

The processor 25 then progresses to step 270 in which it updates the memory 30 to record the total amount of time that the battery 5 has spent respectively in the charge state, discharge state and the equilibrium state. This information can be read from the memory 30 and a processor 25 or output to an external unit as described below. The processor 25 then progresses from step 270 back to the start 100 of the program and the program cycle is repeated.

If at step 230 the processor 25 determines that the battery 5 is not being charged, then it progresses to step 280 in which it determines whether or not the battery 5 is in a state of equilibrium. The processor 25 determines that the battery is in a state of equilibrium if the rate of change of the measured battery terminal voltage is below a predetermined level as discussed above. If the processor 25 determines that the battery is in a state of equilibrium then it calculates the state of charge of the battery (and the corresponding depth of discharge) on the basis of the measured steady terminal voltage and with a correction according to the ambient temperature measured in step 210. The processor carries out these calculations in step 290 of the program and updates the depth of discharge of the battery in memory 30 and also the minimum recorded voltage of the battery if the current measured terminal voltage is less than the previous lowest recorded terminal voltage.

After step 290 the processor progresses to step 300 in which it outputs the measured state of charge of the battery 5 to the display unit 100. The appropriate LED is lit according to the measured state of charge (expressed as a percentage). If the processor at step 280 determines that the battery 5 is not in equilibrium then the measured state of charge and depth of discharge of the battery are not updated and the processor proceeds directly to step 300 in which it displays the measured state of charge of the battery (which has not been updated). From step 300 the processor 25 proceeds to step 270 in which the total amount of time which the battery has spent in charge, discharge and equilibrium states is updated in the memory 30. The processor 25 then proceeds from step 270 back to the start of the program cycle as described above.

Another aspect of the battery monitor 1 is its data storage function, which allows the device to capture and record significant operational data relating to the battery and its environment. This information can be transmitted to an external reading device, preferably by a non-contacting method, to allow more detailed analysis of the service history of a battery. This can be used to investigate failure modes and assess the effects of design enhancements as part of continuous improvement activities. It can also be used as an integral part of a battery management system where information about each section of an electrical system can be co-ordinated to provide enhanced performance or life.

The type of information that can be logged for future display includes Charge cycle number, total charging time, total rest time, total discharge time, over-discharge time, mean depth of discharge, total operating time, maximum charging temperature, mean charging temperature, minimum voltage experienced and calculated remaining life account.

A preferred method for the communication of data is to utilise at least one of the LED components included in the array used to indicate the State of Charge and State of Life conditions. This LED is controlled by the processing chip of the device to switch on and off according to a standard digital communication code (e.g. RS485). This signal is received and decoded by an optical device for display and storage. For example an embodiment of the device uses the LED that indicates the final segment of life, which is conveniently coloured red, as the transmitting component. The meter transmits data at intervals while the battery is in charging mode, in alternation with display of the state of life of the battery.

## Claims

1. A battery monitor for use with a lead acid battery comprising:
a monitor for taking measurements from the battery,
a memory for storing a life counter having a life counter value representing the remaining available life of the battery being monitored,
and a processor configured to detect one or more types of event based on measurements taken by the monitor and to debit the life counter when an event is detected by subtracting from the life counter value a predetermined amount corresponding to the detected event to give a new life counter value representing the remaining available battery life after the event has been detected.

2. A battery monitor according to claim 1 wherein said events comprise a battery discharge/charge cycle.

3. A battery monitor according to claim 2 wherein the processor is configured to debit the life counter by a predetermined amount dependent on the depth of discharge of the detected battery discharge/charge cycle.

4. A battery monitor according to claim 2 or claim 3 wherein the processor is configured to detect a battery discharge/charge cycle event and to debit the life counter by a corresponding predetermined amount for the discharge/charge event each time the processor detects that a new charge event has started.

5. A battery monitor according to claim 4 wherein the processor is configured to detect a charge event is occurring when the monitor indicates that the voltage across the battery terminals has risen above a first predetermined threshold.

6. A battery monitor according to claim 5, wherein the processor is configured to detect that a charge event is occurring when the monitor indicates that the voltage across the battery terminals has risen above a first predetermined threshold and not yet fallen below a second predetermined threshold which is lower than the first predetermined threshold.

7. A battery monitor according to claim 5 or 6 wherein the first predetermined threshold is greater than the maximum possible open circuit voltage of the battery.

8. A battery monitor according to any one of claims 4 to 7 wherein the life counter is debited by an amount determined according to the depth of discharge of the battery before the charging event was detected.

9. A battery monitor according to any one of the preceding claims wherein the processor is configured to detect when the battery is in equilibrium and to debit the life counter by a predetermined amount for each unit time that it detects the battery is in equilibrium.

10. A battery monitor according to any one of the preceding claims wherein the processor is configured to detect when the battery is charging and to debit the life counter by a predetermined amount for each unit time that it detects that the battery is charging.

11. A battery monitor according to claim 10 wherein the processor is configured to detect that the battery is charging when the battery terminal voltage measured by the monitoring means is above a first predetermined threshold greater than the maximum possible open circuit voltage of the battery.

12. A battery monitor according to claim 7 or 11 wherein said first predetermined threshold is 2.3 V per cell of the battery.

13. A battery monitor according to any one of the preceding claims wherein the processor is configured to detect when the battery terminal voltage is below a predetermined level below which irreversible damage will happen to the battery and to debit a predetermined amount from the life counter for each unit time the monitor indicates the battery terminal voltage is below this predetermined level.

14. A battery monitor according to claim 13 wherein the processor judges said predetermined level below which irreversible damage will happen to the battery to be 1.5 V per cell of the battery.

15. A battery monitor according to any of the preceding claims wherein the predetermined debit amounts corresponding to said events are based on predetermined patterns of battery performance.

16. A battery monitor according to any one of the preceding claims wherein the monitor comprises a voltage sensor for measuring the voltage across the terminals of the battery.

17. A battery monitor according to claim 16 wherein the processor is capable of measuring the rate of change of voltage sensed by the voltage sensor and is configured to determine that the battery is in equilibrium when said rate of change is below a threshold level.

18. A battery monitor according to claim 16 or 17 wherein the processor is configured to calculate the state of charge of the battery based on the terminal voltage measured by the voltage sensor.

19. A battery monitor according to claim 16 wherein the battery monitor comprises a battery state of charge measuring apparatus according to any one of claims 26 to 32.

20. A battery monitor according to claim 18 or 19 wherein the battery monitor has a display for displaying both the calculated state of charge of the battery and the estimated remaining life as indicated by the life counter, either simultaneously or separately at different times or in different modes of operation.

21. A battery monitor according to any one of the preceding claims wherein the processor is configured to send an alert signal when the instantaneous voltage, detected by the monitor, across the terminals of battery; falls below a predetermined threshold for at least a predetermined period of time or at least a predetermined number of times.

22. A lead acid battery and a battery monitor according to any one of the above claims wherein the battery monitor is mounted on or in the battery.

23. A lead acid battery and a battery monitor according to claim 22 wherein the battery monitor is integral to the battery.

24. A lead acid battery and a battery monitor according to any one of the above claims wherein said monitor is permanently connected to the terminals of the battery.

25. A lead acid battery and a battery monitor according to any one of claims 22 to 24 wherein the battery monitor and/or the monitor is connected to the battery when the battery is being manufactured and before the battery is first used.

26. A battery state of charge measuring apparatus for use with a lead acid battery comprising:
a voltage sensor for measuring the voltage across the terminals of the battery,
a rate of change measurer for measuring the rate of change with respect to time of the voltage across the terminals of the battery,
a state of charge calculator for calculating the state of charge of the battery based on the voltage measured by the voltage sensor,
an equilibrium determiner for determining that the battery is in equilibrium when the rate of change of the voltage measured by the rate of change measurer is below a predetermined level; and
an output means for outputting the calculated state of charge when the equilibrium determining means determines that the battery is in equilibrium.

27. A battery state of charge measuring apparatus according to claim 26 wherein the rate of change measurer, the state of charge calculator and the equilibrium determiner are integrated into a processor or a program running on a processor.

28. A battery state of charge measuring apparatus according to claim 26 or 27 wherein the output means is configured to output the state of charge to a display.

29. A battery state of charge measuring apparatus according to any of claims 26 to 29 wherein the output means is configured to output the state of charge to a memory.

30. A battery state of charge measuring apparatus according to any one of claims 26 to 29 wherein the state of charge calculator calculates the state of charge only when the equilibrium determiner determines that the battery is in equilibrium.

31. A battery state of charge measuring apparatus according to any of claims 26 to 30 wherein the predetermined level below which the equilibrium determiner determines that the battery is in equilibrium is set at 1.5mV Volts per minute per battery cell.

32. A battery state of charge measuring apparatus according to any one of claims 26 to 31 further including a temperature measurer and wherein the calculator is configured to take into account the measured temperature when calculating the battery state of charge.

33. A lead acid battery and a battery state of charge measurer according to any one of claims 26 to 32 wherein the battery state of charge measuring means is mounted on or in the battery.

34. A lead acid battery and a battery state of charge measuring apparatus according to claim 33 wherein the battery state of charge measuring apparatus is integral with the battery.

35. A lead acid battery and battery state of charge measuring apparatus according to claim 33 or 34 wherein the voltage sensor is permanently connected to the terminals of the battery, preferably during the manufacturing process of the battery.
